# EUROPÄISCHE PATENTANMELDUNG

(11) **EP 3 896 857 A1**
(43) Veröffentlichungstag der Anmeldung: **20.10.2021**
(21) Anmeldenummer: 21168852.8
(22) Anmeldetag: 16.04.2021
(51) Int. Cl.: H03K 17/94

(54) **OPTISCHE SCHALTANORDNUNG SOWIE VERFAHREN ZUM BERÜHRUNGSLOSEN SCHALTEN EINES ELEKTRISCHEN VERBRAUCHERS**

(30) Priorität: 16.04.2020 DE 102020110400
(71) Anmelder: Reime, Gerd, 77815 Bühl (DE)
(72) Erfinder: Reime, Gerd, 77815 Bühl (DE)
(74) Vertreter: RPK Patentanwälte Reinhardt, Pohlmann und Kaufmann Partnerschaft mbB

(57) **Zusammenfassung**

Bei einer Schaltanordnung und einem Verfahren zum berührungslosen Schalten wenigstens eines elektrischen Verbrauchers (V) wird eine autarke, lokale Stromversorgung (10) vorgesehen. Ein optischer Sender (12) einer Steuereinrichtung (S) wird zur Erzeugung eines Lichtsignals zum Aussenden in einen Detektionsraum zur Detektion von Schaltbetätigungen eines Benutzers (B) angesteuert, wobei der Detektionsraum zwischen dem optischen Sender (12) und einem optischen Empfänger (14) aufgespannt ist. Ein Empfangssignal wird aus dem Detektionsraum infolge einer Schaltbetätigung mittels des optischen Empfängers (14) einer Empfangseinrichtung (E) empfangen. Die Steuereinrichtung (S) und/oder die Empfangseinrichtung (E) werden mittels der lokalen Stromversorgung (10) kontinuierlich zeitabschnittsweise mit Strom versorgt. Das Empfangssignal wird zur Erzeugung eines Schaltsignals in Abhängigkeit vorgebbarer oder vorgegebener Randbedingungen in einer Auswerteeinheit (A) ausgewertet. Zur Erzeugung des Schaltsignals wird ein bistabiles Relais (26) verwendet. Dadurch, dass eine Flankendifferenzierung (20) vorgesehen ist, mit der ein auf einer Ausgangsleitung (22) der Auswerteeinheit (A) vorhandener Signalausgang zur Erkennung von in Abhängigkeit der Randbedingungen vorhandener Flanken im Signalausgang differenzierbar ist, und dass eine Ansteuerschaltung (24) zur Ansteuerung eines bistabilen Relais (26) und dazu eingerichtet ist, bei Vorhandensein von Flanken im Signalausgang den Zustand des bistabilen Relais (26) für den Schaltvorgang zu wechseln, werden eine optische Schaltanordnung sowie ein Verfahren zum berührungslosen Schalten bereitgestellt, die bei einem geringen Energiebedarf auch dann einen Schaltvorgang auslösen können, wenn keine Versorgungsspannung am Schaltpunkt vorliegt.

## Beschreibung

Die Erfindung betrifft eine optische Schaltanordnung, die dazu eingerichtet ist, einen elektrischen Verbraucher berührungslos zu schalten, mit den Merkmalen des Anspruches 1 sowie ein Verfahren zum berührungslosen Schalten eines elektrischen Verbrauchers mit den Merkmalen des Anspruches 10.

Wenn im Rahmen dieser Anmeldung von einer "Flanke" oder von einem "flankenbehafteten Signal" die Rede ist, handelt es sich dabei im Signalausgang um eine Flanke, infolge eines Zustandswechsels im Detektionsraum zwischen wenigstens einem Empfänger und wenigstens einem Sender. Dies kann z.B., aber nicht nur, dadurch erfolgen, dass der Signalausgang infolge der Annäherung eines Benutzers von z.B. Low auf High und bei Entfernung des Benutzers von z.B. High auf Low wechselt und sich dadurch eine von einer Flankendifferenzierung erkennbare Flanke als Zustandsänderung im Signalausgang ergibt. Dabei handelt es sich regelmäßig nicht um einen, insbesondere allmählichen, Nulldurchgang des Signals im Signalausgang, da solch eine Flanke nicht zu einem Nulldurchgang führen muss und solch eine Zustandsänderung in der Regel spontan erfolgt.

Optische Schaltanordnungen, die einen optischen Sender und einen optischen Empfänger umfassen, die zwischen sich einen Detektionsraum aufbauen sind allgemein bekannt und werden häufig als Annäherungssensor genutzt. Unterbricht ein Objekt die Lichtstrecke zwischen dem Sender und dem Empfänger wird zum Beispiel eine Alarmfunktion ausgelöst. Üblicherweise sind jedoch bei derartigen optischen Schaltanordnungen ausreichende Stromversorgungen vorhanden, sodass infolge des Lichtsignals oder Unterbrechungssignal eine entsprechende Funktion problemlos geschaltet werden kann (siehe zum Beispiel DE 20 2016 100 532 U1).

Grundsätzlich besteht jedoch bei der Beschaltung von Vorrichtungen, wie sie im Privatbereich aber auch im Industriebereich oder auch in Krankenhäusern und Pflegeheimen vorkommen, häufig das Problem, eine Vorrichtung berührungslos einoder auszuschalten, bei der jedoch am Schalter keine Versorgungsspannung aus dem Stromnetz vorhanden ist. So werden zum Beispiel Schließmechanismen oder Rolladensteuerungen, die hier lediglich als Beispiel genannt sind, ebenso wie Beleuchtungen meist nur mit einem Schaltdraht angesteuert oder erhalten eine Information über ein Bus-System, woraufhin die Stromversorgung des elektrischen Verbrauchers ein- oder ausgeschaltet wird. Eine eigenständige Versorgungsspannung liegt damit am Schalter bzw. Schaltpunkt nicht vor.

Unter einem "Schaltpunkt" wird dabei im Rahmen der Erfindung der Ort oder Punkt verstanden, an dem der Benutzer die Schaltung zum Schalten eines Verbrauchers üblicherweise auslöst, also z.B. ein Schaltelement oder Schalter, der z.B. manuell betätigt wird.

Aus der dem Oberbegriff der unabhängigen Ansprüche zu Grunde liegenden EP 3 029 837 A1 ist ein Näherungsschalter zum berührungslosen Schalten von Verbrauchern mit einem bistabilen Relais bekannt, der an die vorhanden Stromversorgung angeschlossen werden kann. Der Stromverbrauch wird durch die Verwendung des bistabilen Relais reduziert. Durch eine Spannungsdetektor für einen Nulldurchgang der Spannung wird zwar ein Betätigen des Relais optimiert. Dies bleibt jedoch auf die dafür zunächst erforderliche Erfassung von Zustandsänderungen im Detektionsraum ohne Einfluss.

Zur Verringerung der Stand-by-Leistung ist es bekannt, selbsthaltende, bistabile Relais bereitzustellen, die für die Aktivierung und/oder Deaktivierung nur für begrenzte Zeitintervalle mit Energie versorgt werden. Ein derartiger Relaisschalter verbraucht nur für einen kurzen Moment Leistung in den Relaisspulen, wenn der Zustand des Relais (geschlossen oder offen) geändert wird. Ein selbsthaltendes Relais hat zwei Ruhezustände (bistabil). Selbsthaltende Relais werden auch als "Stromstoß-", "Halte-", "Selbsthalte-" oder manchmal als "polarisierte" Relais bezeichnet, wobei all diese Relaistypen im Begriff "selbsthaltendes Relais" eingeschlossen sein sollen. Bei einem selbsthaltenden Relais bleibt, wenn der Strom für seine Betätigung ausgeschaltet ist, das Relais in seinem letzten Zustand. Dies wird beispielsweise durch einen Elektromagneten, der einen Sperrklinkenmechanismus betätigt, oder durch zwei gegenüberliegende Spulen mit einer Übertotpunktfeder oder einen Permanentmagnet zum Halten des Ankers und der Kontakte in Position, während die Spule entspannt ist, oder durch einen Remanenzkern erreicht. Ein erster Impuls oder Stromstoß schaltet das Relais ein, ein zweiter Impuls schaltet es aus. Leistung wird stets nur für den Augenblick verbraucht, in dem der Wechsel von einem Zustand des Relais in den anderen erfolgt. Eine derartige Anwendung ist zum Beispiel aus der DE 21 2015 000 103 U1 bekannt.

Ausgehend von diesem Stand der Technik liegt der vorliegenden Erfindung die Aufgabe zugrunde, eine optische Schaltanordnung sowie ein Verfahren zum berührungslosen Schalten eines elektrischen Verbrauchers bereitzustellen, die bei einem geringen Energiebedarf auch dann einen Schaltvorgang auslösen können, wenn keine Versorgungsspannung am Schaltpunkt vorliegt.

Diese Aufgabe wird durch eine Schaltanordnung mit den Merkmalen des Anspruches 1 sowie durch ein Verfahren mit den Merkmalen des Anspruches 10 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden.

Die Schaltanordnung dient zum berührungslosen Schalten elektrischer Verbraucher und weist eine lokale, autarke Stromversorgung auf. Bei dieser lokalen, autarken Stromversorgung handelt es sich vorzugsweise um eine Batterie und insbesondere bevorzugt um eine Knopfzelle, die einen platzsparenden Aufbau der optischen Schaltanordnung ermöglicht.

Mittels wenigstens einem optischen Sender und wenigstens einem optischen Empfänger wird ein Detektionsraum aufgespannt, der zur Detektion von Schaltbetätigungen eines Benutzers geeignet ist. Der optische Sender wird über eine Steuereinrichtung angesteuert und das vom Sender ausgesandte Signal wird infolge der Schaltbetätigung des Benutzers, zum Beispiel an der Hand des Benutzers reflektiert, so dass sich in der Empfangseinrichtung ein Empfangssignal an dem wenigstens einen Empfänger einstellt, das in der Folge weiterverarbeitet werden kann.

Die lokale Stromversorgung ist dazu eingerichtet, zumindest die Steuereinrichtung für den Sender und/oder die Empfangseinrichtung für den Empfänger kontinuierlich zeitabschnittsweise mit Strom zu versorgen, d.h. z.B. dauerhaft in vorzugsweise kleinen Zeitabständen hintereinander. Mit anderen Worten werden in regelmäßigen Abständen Lichtpulse vom Sender ausgesandt und der Empfänger wird entsprechend wirksam geschaltet, um von den Lichtpulsen verursachte, zum Beispiel reflektierte Signale zu empfangen. Zur Auswertung des Empfangssignals ist eine Auswerteeinheit vorgesehen, wobei als Ergebnis der Auswertung ein Schaltsignal zum Schalten des elektrischen Verbrauchers in Abhängigkeit vorgebbarer oder vorgegebener Randbedingungen erzeugt wird. Diese Randbedingungen sind entsprechende Schwellwerte oder auch umgebungsabhängige Randbedingungen wie zum Beispiel temperaturabhängige Werte, die eine zuverlässige Funktion der Schaltanordnung und ein Erkennen von tatsächlich auch beabsichtigten Schaltbetätigungen sicher stellen.

Ausgehend von einer Signalausgabe der Auswerteeinheit ergibt sich auf einer Ausgangsleitung in Abhängigkeit der zuvor erfolgten Auswertung und Randbedingungen ein Signalausgang, der von einer Flankendifferenzierung differenziert wird. Ergibt sich im Signalausgang eine Flanke, indem der Signalausgang infolge der Annäherung des Benutzers von z.B. Low auf High und bei Entfernung des Benutzers von z.B. High auf Low wechselt, so wird diese Flanke von der Flankendifferenzierung erkannt. Infolge der erkannten Flanke wird ein Signal an eine Ansteuerschaltung weitergeben. Unter diesem Weitergeben ist die Weitergabe insbesondere eines Stromstoßes zu verstehen, der dafür bestimmt ist und auch dafür ausreichend ist, ein bistabiles Relais für den Schaltvorgang des Verbrauchers zu schalten, das heißt den Zustand des Relais zu wechseln. Da das bistabile Relais nach dem Zustandswechsel den Zustand beibehält, ist kein weiterer Strom erforderlich, bis der nächste Schaltvorgang aus der Schaltbetätigung des Benutzers abgeleitet wird. Ein weiterer Energiebedarf oder Stromverbrauch fällt in dieser Zeit also nicht an. Da gleichzeitig lediglich die Flanken im Signalausgang detektiert werden, um den Schaltvorgang auszulösen, ist auch hierfür nur wenig Energie aufzubringen, sodass sich insgesamt eine energiesparende Lösung ergibt.

Eine derartige Lösung hat auch den Vorteil, dass mit einer lokalen, autarken Stromversorgung über viele Jahre hinweg ein Schalten eines Verbrauchers möglich ist, ohne dass hierfür der Schalter berührt werden muss. Es genügt, wenn im Detektionsraum zwischen optischem Sender und optischem Empfänger eine erkennbare Schaltbetätigung zum Beispiel in Form einer Geste durch den Benutzer erfolgt. Diese Geste führt infolge des Empfangssignals und der Auswertung des Empfangssignals bis hin zur Signalausgabe zu dem gewünschten Stromstoß, der den Zustand des Relais ändert. Da keine weitere Energie außer der aus der autarken, lokalen Stromversorgung kommenden Energie bereitgestellt werden muss, kann mit der Schaltanordnung berührungslos vorzugsweise auch dann ein Verbraucher geschaltet werden, wenn am Schaltpunkt, wie zum Beispiel einem Lichtschalter oder an der Rolladenschaltung keine eigene Versorgungsspannung vorliegt. Damit können diese Schalter berührungsfrei betrieben werden, sodass sich ein hygienischer Betrieb verwirklichen lässt. Damit eröffnen sich auch viele Anwendungsbereiche zum Beispiel im Sanitärbereich oder gerade in Kliniken und Heimen, in denen es auf erhöhte hygienische Anforderungen gerade ankommt.

Vorteilhafterweise weist die Auswerteeinheit wenigstens einen Flip-Flop auf, der dazu eingerichtet ist, bei Überschreiten eines Schwellwerts über die Signalausgabe ein flankenbehaftetes Signal auf der Ausgangsleitung an das potentialfreie, bistabile Relais auszugeben, sofern im Signalausgang Flanken detektiert werden. Die Verwendung des Flip-Flops führt zu der gewünschten zwischen z.B. High und Low wechselnden Ausgabe eines Ausgangssignals, das dann hinsichtlich seiner Flanken differenziert wird. Werden Flanken erkannt, führt dies über die Ansteuerschaltung zu dem gewünschten Stromstoß zum Umschalten des bistabilen Relais. Das Flip-Flop wird zeitabschnittsweise wieder zurückgesetzt und kann ohne großen Stromverbrauch wieder gesetzt werden. Dieses Bauelement trägt damit ebenfalls zum energiesparenden Aufbau der Schaltanordnung bei.

Vorzugsweise ist nach der Auswerteeinheit das Ausgangssignal vorhanden, wenn ein Benutzer sich angenähert hat, und nicht vorhanden, wenn kein Benutzer im Detektionsraum anwesend ist. Hierzu muss kein dauerhafter Strom fließen. Dies hat den Vorteil, dass auch an dieser Stelle der Energieverbrauch verringert werden kann.

In der Regel wird vorzugsweise die Leitung zum elektrischen Verbraucher eine einphasige Leitung sein, das heißt es handelt sich um einen "Schaltdraht", der durch den Schalter geschleift ist. Ebenso kann es sich dabei um eine Leitung eines Bus-Systems handeln. Besonders bevorzugt handelt es sich bei der Leitung zum elektrischen Verbraucher um eine Zwei-Draht-Leitung. Diese Ausgestaltungen können vorzugsweise grundsätzlich in Verbindung mit der optischen Schaltanordnung verwendet werden, da eine gesonderte Versorgungsspannung am Schaltpunkt, das heißt also an dem Ort, an dem der Benutzer die Schaltung auslöst, nicht mehr erforderlich ist.

Vorteilhafterweise ist ein Clock-Generator vorgesehen, der dazu eingerichtet ist, den wenigstens einen Sender und den wenigstens einen optischen Empfänger über ein Timing-Element anzusteuern. Dadurch ist es möglich, die Zeiten, in denen die optischen Elemente, also der optische Empfänger und der optische Sender aktiv sind, zeitlich auf bestimmte Zeitfenster zu begrenzen. Auch der zeitabschnittsweise Betrieb von Sender und Empfänger trägt zur Energieersparnis bei.

Vorzugsweise ist ein Clock-Generator vorgesehen, der dazu eingerichtet ist, das Flip-Flop über ein Timing-Element zu Beginn des Messzyklus zurückzusetzen. Damit kann für jeden Messvorgang bzw. Sendevorgang des Lichtsignals erneut geprüft werden, ob die Annäherung des Benutzers noch vorhanden ist. Nach dem Setzen des Flip-Flops kann das Flip-Flop im gesetzten Zustand verbleiben und wird durch das nächste Timing-Signal wieder zurückgesetzt. Bei einem so gesetzten Flip-Flop wird während des gesetzten Zustands keine Energie verbraucht.

Wenn der optische Sender über das Timing-Element so angesteuert wird, dass vorzugsweise eine Betriebsdauer von ≤ 100 ns bei einer Pausenlänge von mehr als 80 ms vorliegt, ergeben sich vorteilhafte Betriebszeiten für Sender und Empfänger. Diese Abstände sind ausreichend, um zuverlässig Schaltbetätigungen durch einen Benutzer zu erfassen, gleichzeitig ist aber die Betriebsdauer so gering, dass Energie gespart werden kann.

Bevorzugterweise weist die Schaltanordnung einen ersten Schellwertdetektor und einen zweiten Schwellwertdetektor auf, die dazu eingerichtet sind, bei Überschreiten eines in Abhängigkeit der Randbedingungen ersten Schwellwerts des ersten Schwellwertdetektors und Überschreiten eines gegenüber dem ersten Schwellwert höheren Schwellwerts des zweiten Schwellwertdetektors das Flip-Flop zu setzen. Dadurch ist eine Abstimmung auf die Randbedingungen gut erreichbar, so dass zuverlässig mit geringem Aufwand ein Schaltvorgang ausgelöst werden kann.

Wird in einer alternativen Ausführungsform vorzugsweise ein weiteres Flip-Flop vor der Flankendifferenzierung angeordnet und beschaltet, ist ein Betrieb des Schalters auch als Wechselschalter ohne größere Umstellungen mit der ansonsten ein und derselben Schaltanordnung möglich.

Vorzugsweise hat sich in der Praxis herausgestellt, dass die Schaltungsanordnung bei zehn Pulsen des optischen Senders pro Sekunde einen Strom von ≤ 500 nA pro Stunde bei einer Spannung von 3 V benötigt. Die tatsächlich ermittelten Werte liegen in der Praxis sogar noch niedriger, nämlich bei 280 nA. Ein derart geringer Stromverbrauch führt zu einer äußerst langen Lebensdauer der autarken, lokalen Stromversorgung, die vorzugsweise eine Batterie und höchst vorzugsweise eine Knopfzelle ist, ebenso aber auch durch einen Akkumulator gebildet sein kann, der über das Stromnetz und/oder eine Solarzelle nachgeladen werden kann.

Verfahrensgemäß wird zum berührungslosen Schalten wenigstens eines elektrischen Verbrauchers eine autarke, lokale Stromversorgung bereitgestellt. Wenigstens ein optischer Sender einer Steuereinrichtung wird zur Erzeugung eines Lichtsignals zum Aussenden in einen Detektionsraum zur Detektion von Schaltbetätigungen eines Benutzers angesteuert, welcher Detektionsraum zwischen dem wenigstens einen optischen Sender und wenigstens einem optischen Empfänger aufgespannt ist.

Ein Empfangssignal wird aus dem Detektionsraum infolge einer Schaltbetätigung mittels des wenigstens einen optischen Empfängers einer Empfangseinrichtung empfangen. Die Steuereinrichtung und/oder die Empfangseinrichtung werden mittels der lokalen Stromversorgung kontinuierlich zeitabschnittsweise mit Strom versorgt. Das Empfangssignal wird zur Erzeugung eines Schaltsignals in Abhängigkeit vorgebbarer oder vorgegebener Randbedingungen in einer Auswerteeinheit ausgewertet. Ein auf einer Ausgangsleitung der Auswerteeinheit vorhandener Signalausgang ist zur Erkennung von in Abhängigkeit der Randbedingungen vorhandener Flanken im Signalausgang differenzierbar. Mindestens ein bistabiles Relais wird bei Vorhandensein von Flanken im Signalausgang angesteuert, um den Zustand des bistabilen Relais für den Schaltvorgang zu wechseln. Wie bereits hinsichtlich der Schaltanordnung erwähnt, ergibt sich mit dieser Lösung eine energiesparende Schaltung zur Auslösung eines Schaltvorgangs, die vorzugsweise auch mit einer autarken Stromversorgung wie einer Batterie, Knopfzelle oder eines Akkumulators über viele Jahre betrieben werden kann, selbst wenn keine weitere Versorgungsspannung vom Netz am Schaltpunkt vorhanden ist. Weitere Vorteile ergeben sich aus den Ausführungen zur Schaltanordnung.

Dadurch, dass vorzugsweise wenigstens ein Flip-Flop der Auswerteeinheit bei Überschreiten eines Schwellwerts im Signalausgang über eine Signalausgabe ein flankenbehaftetes Signal auf der Ausgangsleitung an das potentialfreie, bistabile Relais ausgibt, ergibt sich eine energiesparende Schaltung, da das Flip-Flop im gesetzten Zustand verbleibt und erst durch das nächste Timing-Signal wieder zurückgesetzt wird.

Indem ein Clock-Generator den wenigstens einen optischen Sender und/oder den wenigstens einen optischen Empfänger über ein Timing-Element zeitweise ansteuert, kann in den Pausen zwischen der Ansteuerung Energie eingespart werden. Ein dauerhafter Betrieb ist angesichts der Bewegungsgeschwindigkeit des Benutzers im Vergleich zu den Schaltpausen nicht erforderlich.

Wird bevorzugterweise ein Clock-Generator verwendet, um den Flip-Flop zu Beginn des Messzyklus über ein Timing-Element zurückzusetzen, ist kein dauerhafter Strom erforderlich, so dass auch dadurch Energie eingespart werden kann.

Vorzugsweise betreibt ein Timing-Element den optischen Sender mit einer Betriebsdauer von ≤ 100 ns bei einer Pausenlänge von mehr als 80 ms. Damit ist für den Großteil der Zeit keine Energie für den Betrieb erforderlich. Es ergibt sich ein energiesparender Betrieb.

Um vorteilhaft das Verfahren vielseitig auch für Wechselschaltungen verwenden zu können, ist lediglich ein weiteres Flip-Flop vor der Flankendifferenzierung und vorzugsweise nach der Signalausgabe zwischenzuschalten.

Wird vorzugsweise als autarke, lokale Stromversorgung eine Batterie, insbesondere eine Knopfzelle verwendet, ergibt sich eine netzunabhängige Lösung, die dennoch über Jahre stromsparend betrieben werden kann. Gleichzeitig ist ein vielseitiger Einsatz, z.B. auch in hygienisch anspruchsvollen Bereichen möglich, wenn nachträglich eine Umrüstung von Schaltern auf ein berührungsloses Schalten erwünscht ist.

Weitere Vorteile ergeben sich aus den Unteransprüchen und der nachfolgenden Beschreibung eines bevorzugten Ausführungsbeispiels.

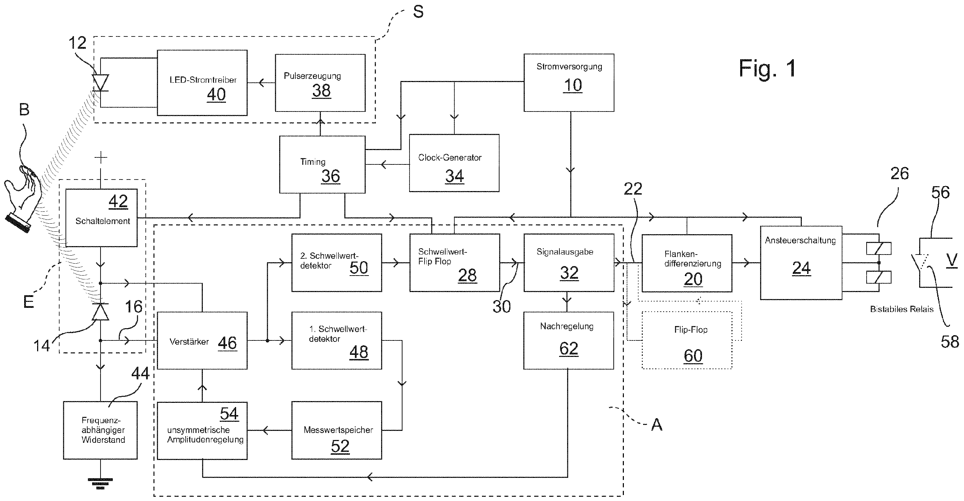

Im Folgenden wird die Erfindung anhand eines Ausführungsbeispiels näher erläutert. Fig. 1 zeigt ein Blockschaltbild der Schaltungsanordnung mit optischem Sender, optischem Empfänger und Verbraucher.

### Beschreibung bevorzugter Ausführungsbeispiele

Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

Figur 1 zeigt ein Blockschaltbild einer optischen Schaltanordnung, mit der ein elektrischer Verbraucher V berührungslos zu schalten ist. In der Schaltanordnung sind gestrichelt mehrere Blöcke eingezeichnet, nämlich eine Steuereinrichtung S zur Ansteuerung wenigstens eines optischen Senders 12, der im Ausführungsbeispiel durch eine LED gebildet ist. Vorgesehen ist ferner eine Empfangseinrichtung E, die den wenigstens einen optischen Empfänger 14 umfasst, der im Ausführungsbeispiel durch eine Fotodiode gebildet ist. Von der Empfangseinrichtung E gelangt ein Empfangssignal zum Beispiel über die Leitung 16 an die Auswerteeinheit A, die über die Ausgangsleitung 22 ein Schaltsignal ausgibt.

Zum Betrieb der Schaltungsanordnung ist wenigstens eine lokale, autarke Stromversorgung 10 vorgesehen, die durch eine Batterie, insbesondere ein Knopfzelle oder einen Akkumulator gebildet sein kann, der über das Stromnetz und/oder eine Solarzelle nachladbar ist. Zwischen dem wenigstens einen optischen Sender 12 und dem wenigsten einen optischen Empfänger 14 ist ein Detektionsraum zur Detektion von Schaltbetätigungen eines Benutzers B aufgespannt. Diese Schaltbetätigungen erfolgen berührungslos. Ein vom optischen Sender ausgesandter Lichtstrahl wird dabei am Benutzer reflektiert, was zu einem entsprechenden Eingang am Empfänger 14 und damit zum Empfangssignal führt.

Die lokale Stromversorgung 10 ist dazu eingerichtet, die Steuereinrichtung S und/oder die Empfangseinrichtung E kontinuierlich zeitabschnittsweise mit Strom zu versorgen. Dies bedeutet vorzugsweise, dass eine Stromversorgung dauerhaft in vorzugsweise kleinen aufeinanderfolgenden Zeitabständen erfolgt. In der Regel versorgt die Stromversorgung 10 auch die Auswerteeinheit A mit Strom.

Im Ausführungsbeispiel der Figur 1 ist die lokale Stromversorgung 10 mit dem Clock-Generator 34 und dem Timing-Element 36 verbunden, über die Steuereinrichtung S als auch die Empfangseinrichtung E mit Strom versorgt werden. Ferner versorgt die lokale Stromversorgung 10 den Flip-Flop 28 sowie die Flankendifferenzierung 20 als auch die Ansteuerschaltung 24 mit Strom.

Die Auswerteeinheit A ist zur Auswertung des Empfangssignals zur Erzeugung eines Schaltsignals vorgesehen, das zum Schalten des Verbrauchers V bestimmt ist und sich in Abhängigkeit vorgebbarer oder vorgegebener Randbedingungen ergibt. Diese Randbedingungen können einerseits äußere Randbedingungen sein, wie zum Beispiel eine veränderliche Spannung der lokalen Stromversorgung oder Temperatur, in der Regel handelt es sich aber um vorgebbare oder veränderbare Schwellwerte zur zuverlässigen Erkennung der Schaltbetätigungen des Benutzers B, die über die Schwellwertdetektoren 48, 50 ermittelt werden, worauf unten noch näher eingegangen wird.

In Figur 1 auf der rechten Seite ist neben der Auswerteeinheit A eine Flankendifferenzierung 20 vorgesehen, die einen auf einer Ausgangsleitung 22 der Auswerteeinheit A vorhandenen Signalausgang zur Erkennung von Flanken differenziert. Ferner ist in Fig.1 rechts von der Flankendifferenzierung 20 eine Ansteuerschaltung 24 vorgesehen, die zur Ansteuerung wenigstens eines bistabilen Relais 26 bestimmt ist. Die Ansteuerschaltung 24 ist dazu eingerichtet, bei Vorhandensein von Flanken im Signalausgang den Zustand des bistabilen Relais 26 für den Schaltvorgang des elektrischen Verbrauchers V zu wechseln.

Eine Flanke oder ein flankenbehaftetes Signal liegt im Signalausgang z.B. infolge eines Zustandswechsels im Detektionsraum zwischen dem wenigstens einem Empfänger 14 und wenigstens einem Sender 12 vor. Sie kann z.B., aber nicht nur, dadurch hervorgerufen werden, dass der Signalausgang infolge der Annäherung eines Benutzers von z.B. Low auf High und bei Entfernung des Benutzers von z.B. High auf Low wechselt und sich dadurch eine von der Flankendifferenzierung 20 erkennbare Flanke als Zustandsänderung im Signalausgang ergibt. Dabei handelt es sich regelmäßig nicht um einen, insbesondere allmählichen, Nulldurchgang des Signals im Signalausgang auf der Ausgangsleitung 22, da solch eine Flanke in der Regel nicht zu einem Nulldurchgang führen muss und solch eine Zustandsänderung in der Regel im Vergleich zu einem um Null oszillierenden Signal zeitlich eher abrupt und spontan erfolgt.

Das bistabile Relais 26 hat den Vorteil, dass es als selbsthaltendes Relais zwei Ruhezustände hat. Unter dem Begriff "selbsthaltendes Relais" werden dabei auch "Stromstoß-", "Halte-", "Selbsthalte-" oder auch "polarisierte" Relais verstanden. Beim selbsthaltenden Relais bleibt, wenn der Strom für seine Betätigung ausgeschaltet ist, das Relais in seinem letzten Zustand, ohne dass weitere Energie erforderlich ist. Damit kann ein geschalteter oder auch ausgeschalteter Zustand ohne weitere Energie beibehalten werden.

Aus der autarken, lokalen Stromversorgung 10 wird zunächst der Clock-Generator 34 versorgt. Dieser gibt einen Takt vor, der an ein Timing-Element 36 übermittelt wird. Durch das Timing-Element 36 werden zu Beginn eines Messzyklus, vorzugsweise jedes Messzyklus, die Steuereinrichtung S und die Empfangseinrichtung E aktiviert und das Flip-Flop 28 zurückgesetzt. Von diesem Timing-Element 36 aus werden damit die Steuereinrichtung S und die Empfangseinrichtung E mit Strom versorgt und angesteuert. Ein Timing-Signal geht an die Pulserzeugung 38 für den LED-Stromtreiber 40, um den wenigstens einen optischen Sender 12, im Ausführungsbeispiel eine LED zu betätigen. Üblicherweise erfolgt diese Betätigung im Ausführungsbeispiel zehn Mal pro Sekunde für 30 ns. Es sind aber auch andere Frequenzen und Betätigungszeiten möglich.

Das Timing-Signal wird auch einem Schaltelement 42 für den wenigstens einen Empfänger 14 aufgegeben. Durch das Schaltelement 42 wird insofern der wenigstens eine Empfänger 14 für die Zeit wirksam geschalten, in der der optische Sender 12 ein Lichtsignal aussendet. Wird das Lichtsignal infolge der Schaltbetätigung eines Benutzers B in den Empfänger 14 reflektiert, ergibt sich dort ein Empfangssignal. Dieses Empfangssignal wird über den gegen Masse angeordneten frequenzabhängigen Widerstand 44 nochmals so beeinflusst, dass Gleichlicht keine Wirkung im Verstärker 46 ausübt und nur der ausgesandte reflektierte Puls in Folge des Lichtsignals gesehen wird.

Das Empfangssignal wird über Leitung 16 dem Verstärker 46 zugeleitet und an dessen Ausgang in Fig. 1 auf der rechten Seite des Verstärkers 46 zunächst an einen ersten Schwellwertdetektor 48 übergeben. Dieser erste Schwellwertdetektor 48 hat die Aufgabe, permanent bestehende Reflexionen zu unterdrücken, indem ein Empfangssignal, das infolge einer Reflexion den ersten Schwellwert des ersten Schwellwertdetektors 48 nur zeitweise überschreitet, zu einer Regelung des Verstärkers 46 führt, so dass der erste Schwellwert nicht dauerhaft überschritten wird. Wird der erste Schwellwert aber regelmäßig überschritten, so regelt die unsymmetrische Amplitudenregelung 54 den Verstärker 46 langsam nach, bis der erste Schwellwert statistisch unterschritten ist. Eine statische betrachte Überschreitung kann auch gegeben sein, wenn der Verstärker 46 infolge der Regelung so sehr verstärkt, dass ein Rauschen den ersten Schwellwert überschreitet. Ist der erste Schwellwert unterschritten, regelt die unsymmetrische Amplitudenregelung den Verstärker 46 jedoch im Vergleich schnell wieder zu einem höheren Verstärkungsgrad nach, bis der erste Schwellwertdetektor 48 wieder überschritten wird.

Zur Erklärung der Begriffe: Ein Langsames Nachregeln kann bedeuten, dass bei einem Überschreiten des ersten Schwellwerts die unsymmetrische Amplitudenregelung 54 etwa eine Minute benötigt, bis sie den Verstärker 46 so hinsichtlich seiner Verstärkung heruntergeregelt hat, dass der erste Schwellwert nicht mehr kontinuierlich überschritten wird. Eine im Vergleich dazu schnelle Nachregelung des Verstärkergrads bedeutet, dass bei Entfernung einer zuvor bestehenden, zeitlich langen Reflexion der Verstärkungsgrad des Verstärkers 46 innerhalb von z.B. 500 ms so erhöht wird, dass der erste Schwellwert nur zeitweise überschritten wird.

Der jeweils vom ersten Schwellwertdetektor 48 erkannte Wert wird als Referenzwert in einem Messwertspeicher 52 hinterlegt und damit für die nächsten Messzyklen zwischengespeichert.

Der Ausgang des Verstärkers 46 steht zugleich mit einem zweiten Schwellwertdetektor 50 in Verbindung. Dieser zweite Schwellwertdetektor 50 ist dafür eingerichtet zu erkennen, ob das Empfangssignal tatsächlich von einer Schaltbetätigung eines Benutzers B stammt. Ist das vom Verstärker 46 kommende Signal höher als der zweite Schwellwert des zweiten Schwellwertdetektors 50, wird das Flip-Flop 28 gesetzt, das über das Timing-Element 36 zeitabschnittsweise zu Beginn jedes Messzyklus zurückgesetzt wurde. Gelangt vom zweiten Schwellwertdetektor 50 ein Wert an das durch das Timing-Element 36 zurückgesetzte Flip-Flop 28, ergibt sich an seinem Ausgang 30 bei Überschreiten des Schwellwerts ein Ausgangssignal, das in die Signalausgabe 32 gelangt. Wird dabei das über das Timing-Element 36 zu Beginn jedes Messzyklus bzw. Sendevorgangs des Lichtsignals zurückgesetzte Flip-Flop 28 aufgrund der Anwesenheit des Benutzers B im Detektionsraum sofort wieder gesetzt, gibt die Signalausgabe 32 ein kontinuierliches Signal (in der Regel z.B. High) aus.

Der zweite Schwellwertdetektor 50 setzt also das Flip-Flop 28, das dann bis zum nächsten Messvorgang in der gesetzten Position verbleibt. Zu Beginn des nächsten Messvorgangs wird das Flip-Flop 28 über das Timing-Element 36 geweckt und zurückgesetzt. Ist ein Benutzer dann anwesend, wird es wieder gesetzt. Nach der Signalausgabe 32 ergibt sich auf der Ausgangsleitung 22, die zugleich der Ausgang der Auswerteeinheit A ist, bei Anwesenheit eines Benutzers B ein gleichbleibendes Signal z.B. High, das sich erst bei Entfernung des Benutzers B wieder zu z.B. Low ändert. Der Wechsel zwischen z.B. High und Low bzw. die dadurch entstehenden Flanken des flankenbehafteten Signals im Signalausgang werden in der Flankendifferenzierung 20 detektiert.

Erkennt die Flankendifferenzierung 20 eine Flanke, erfolgt ein Signal, vorzugsweise ein Stromstoß, über die Ansteuerschaltung 24 an das bistabile Relais 26, das dadurch seinen Zustand wechselt und den Verbraucher V ein- oder ausschaltet.

Durch die Verwendung des Timing-Elements 36 ist es möglich, den optischen Sender 12 mit einer Betriebsdauer von ≤ 100 µs, im Ausführungsbeispiel 30 ns bei einer Pausenlänge von ≥ 80 ms, im Ausführungsbeispiel 100 ms zu betreiben. Diese Zeiten sind ausreichend, um eine Schaltbetätigung durch einen Benutzer B zuverlässig zu erkennen.

In einem bevorzugten Ausführungsbeispiel kann ergänzend eine Nachregelung 62 vorgesehen sein, der das von der Signalausgabe 32 an die Flankendifferenzierung 20 übermittelte Ausgangssignal der Auswerteeinheit A ebenfalls zugeleitet wird. Stellt diese Nachregelung z.B. eine Anwesenheit des Benutzers B im Detektionsraum für z.B. mehr als zehn Sekunden fest, gibt die Nachregelung ein Signal an die unsymmetrische Amplitudenregelung 54 aus, um diese zu veranlassen, schneller zu regeln, um sicherzustellen, dass z.B. eine Reflexion durch eine spontane Verschmutzung auf der Oberfläche eines möglichen Gehäuses dauerhaft ausgeregelt werden kann und gleichwohl eine Betätigung durch einen Benutzer ermöglicht wird.

Die Leitung 56 zum elektrischen Verbraucher V ist vorzugsweise einphasig, das heißt es ist eine Schaltleitung, die durch den Schalter 58 durchgeschleift ist. Mit ihr können Phase oder Masse auf den Verbraucher geschaltet werden. Bei dieser Leitung kann es sich auch um die Leitung eins Bus-Systems handeln, über die Informationen an den Schalter 58 und/oder Verbraucher V gelangen. Eine derartige Leitung 56 ist meist eine Zwei-Draht-Leitung, es können jedoch auch mehr Phasen und mehr Drähte je Leitung vorgesehen sein. Grundsätzlich ist die Schaltanordnung jedoch insbesondere dann geeignet, wenn am Schaltpunkt, also im Bereich, in dem das bistabile Relais 26 den Schaltvorgang auslöst, keine eigene Versorgungsspannung vorhanden ist.

Die Schaltanordnung kann sowohl mit einem einfachen Ein-/Ausschalter betrieben werden als auch mit einem Wechselschalter. Für den Betrieb der Schaltanordnung mit einem Wechselschalter sind in Fig. 1 weitere Elemente gestrichelt eingezeichnet. Dabei handelt es sich zum einen um die zweite Schaltstellung des Schalters 58, der dann als Wechselschalter beschaltet ist und zum anderen um das weitere Flip-Flop 60, das vor die Flankendifferenzierung 20, vorzugsweise zwischen die Signalausgabe 32 und die Flankendifferenzierung 20 geschaltet ist, so dass der Signalausgang erst durch das Flip-Flop 60 geführt wird, bevor er zur Flankendifferenzierung 20 gelangt. Mit jedem Wechsel im Signalausgang von z.B. High auf Low wird dieses Flip-Flop 60 wechselweise gesetzt oder zurückgesetzt, so dass dadurch der Wechselschalter geschaltet werden kann.

Es hat sich in einem Ausführungsbeispiel als besonders bevorzugt ergeben, mittels des Timing-Elements 36 den optischen Sender 12 für eine Betriebsdauer von 30 ns bei einer Pausenlänge von 100 ms zu betreiben. Mit den dann rund zehn Pulsen des optischen Senders pro Sekunde ergibt sich ein Strom von ≤ 500 nA bei einer Spannung von 3 V. Im konkreten Ausführungsbeispiel betrug der Strom 280 nA.

Der verfahrensgemäße Ablauf ergibt sich bereits aus der bisher erfolgten Erläuterung, so dass hier nur das Grundprinzip nochmals kurz zusammengefasst wird.

Verfahrensgemäß wird zum berührungslosen Schalten wenigstens eines elektrischen Verbrauchers V eine autarke, lokale Stromversorgung 10 bereitgestellt. Wenigstens ein optischer Sender 12 einer Steuereinrichtung S wird zur Erzeugung eines Lichtsignals zum Aussenden in einen Detektionsraum zur Detektion von Schaltbetätigungen eines Benutzers B angesteuert, welcher Detektionsraum zwischen dem wenigstens einen optischen Sender 12 und wenigstens einem optischen Empfänger 14 aufgespannt ist. Ein Empfangssignal wird aus dem Detektionsraum infolge einer Schaltbetätigung mittels des wenigstens einen optischen Empfängers 14 einer Empfangseinrichtung E empfangen. Die Steuereinrichtung S und/oder die Empfangseinrichtung E werden mittels der lokalen Stromversorgung 10 kontinuierlich zeitabschnittsweise mit Strom versorgt. Das Empfangssignal wird zur Erzeugung eines Schaltsignals in Abhängigkeit vorgebbarer oder vorgegebener Randbedingungen in einer Auswerteeinheit A ausgewertet. Ein auf einer Ausgangsleitung 22 der Auswerteeinheit A vorhandener flankenbehafteter Signalausgang ist zur Erkennung von in Abhängigkeit der Randbedingungen vorhandener Flanken im Signalausgang differenzierbar. Mindestens ein bistabiles Relais 26 wird bei Vorhandensein von Flanken im Signalausgang angesteuert, um den Zustand des bistabilen Relais 26 für den Schaltvorgang zu wechseln.

Als autarke, lokale Stromversorgung 10 wird vorzugsweise eine Batterie, insbesondere eine Knopfzelle verwendet.

### Bezugszeichenliste

- 10: Stromversorgung
- 12: optischer Sender
- 14: optischer Empfänger
- 16: Leitung
- 20: Flankendifferenzierung
- 22: Ausgangsleitung von A
- 24: Ansteuerschaltung
- 26: bistabiles Relais
- 28: Flip-Flop
- 30: Ausgang von 28
- 32: Signalausgabe
- 34: Clock-Generator
- 36: Timing-Element
- 38: Pulserzeugung
- 40: LED-Stromtreiber
- 42: Schaltelement
- 44: Frequenzabhängiger Widerstand
- 46: Verstärker
- 48: erster Schwellwertdetektor
- 50: zweiter Schwellwertdetektor
- 52: Messwertspeicher
- 54: unsymmetrische Amplitudenregelung
- 56: Leitung zu V
- 58: Schalter
- 60: Flip-Flop
- 62: Nachregelung
- A: Auswerteeinheit
- B: Benutzer
- E: Empfangseinrichtung
- S: Steuereinrichtung
- V: Verbraucher

## Patentansprüche

1. Optische Schaltanordnung, die dazu eingerichtet ist, wenigstens einen elektrischen Verbraucher (V) berührungslos zu schalten, mit
- einer autarken, lokalen Stromversorgung (10),
- wenigstens einem optischen Sender (12) und wenigstens einem optischen Empfänger (14), die zwischen sich einen Detektionsraum zur Detektion von Schaltbetätigungen eines Benutzers (B) aufspannen,
- einer Steuereinrichtung (S), eingerichtet zur Ansteuerung des wenigstens einen optischen Senders (12),
- einer Empfangseinrichtung (E), eingerichtet zum Empfangen eines Empfangssignals des wenigstens einen optischen Empfängers (14) aus dem Detektionsraum infolge einer Schaltbetätigung,
- einer Ansteuerschaltung (24), die eingerichtet ist zur Ansteuerung mindestens eines bistabilen Relais (26),
- wobei die lokale Stromversorgung (10) dazu eingerichtet ist, wenigstens die Steuereinrichtung (S) und/oder die Empfangseinrichtung (E) kontinuierlich zeitabschnittsweise mit Strom zu versorgen,
- einer Auswerteeinheit (A) zur Auswertung des Empfangssignals zur Erzeugung eines Schaltsignals unter Verwendung des bistabilen Relais (26) für einen Schalter (58) in Abhängigkeit vorgebbarer oder vorgegebener Randbedingungen,
**dadurch gekennzeichnet, dass** eine Flankendifferenzierung (20) vorgesehen ist, die dazu eingerichtet ist, einen auf einer Ausgangsleitung (22) der Auswerteeinheit (A) vorhandenen Signalausgang zur Erkennung von in Abhängigkeit der Randbedingungen vorhandener Flanken im Signalausgang zu differenzieren, und dass die Ansteuerschaltung (24) dazu eingerichtet ist, bei Vorhandensein von Flanken im Signalausgang den Zustand des bistabilen Relais (26) für den Schaltvorgang zu wechseln.

2. Schaltanordnung nach Anspruch 1, **dadurch gekennzeichnet, dass** die Auswerteeinheit (A) wenigstens ein Flip-Flop (28) aufweist, das dazu eingerichtet ist, bei Überschreiten eines Schwellwerts im Signalausgang über eine Signalausgabe (32) ein flankenbehaftetes Signal auf der Ausgangsleitung (22) an das potentialfreie, bistabile Relais (26) auszugeben.

3. Verfahren nach Anspruch 1 oder 2, **dadurch gekennzeichnet, dass** die Flankendifferenzierung (20) dazu eingerichtet ist, Flanken in einem flankenbehafteten Signal im Signalausgang auf der Ausgangsleitung (22) infolge einer Zustandsänderung im Detektionsraum zu differenzieren, insbesondere infolge der Annäherung und/oder Entfernung eines Objekts oder Benutzers (B).

4. Schaltanordnung nach einem der vorhergehenden Ansprüche, **dadurch gekennzeichnet, dass** ein Clock-Generator (34) vorgesehen ist, der dazu eingerichtet ist, den Flip-Flop (28) über ein Timing-Element (36) zu Beginn eines Messzyklus zurückzusetzen und/oder den wenigstens einen optischen Sender (12) und/oder den wenigstens einen optischen Empfänger (14) über ein Timing-Element (36) zeitweise anzusteuern.

5. Schaltanordnung nach einem der vorhergehenden Ansprüche, **dadurch gekennzeichnet, dass** ein Timing-Element (36) vorgesehen ist, dass dazu eingerichtet ist, den optischen Sender (12) mit einer Betriebsdauer von ≤ 100 ns bei einer Pausenlänge von mehr als 80 ms zu betreiben.

6. Schaltanordnung nach einem der vorhergehenden Ansprüche, **dadurch gekennzeichnet, dass** ein erster Schwellwertdetektor (48) und ein zweiter Schwellwertdetektor (50) vorgesehen sind, die dazu eingerichtet sind, bei Überschreiten eines in Abhängigkeit der Randbedingungen ersten Schwellwerts des ersten Schwellwertdetektors und Überschreiten eines gegenüber dem ersten Schwellwert höheren Schwellwerts des zweiten Schwellwertdetektors (50) das Flip-Flop (28) zu setzen.

7. Schaltanordnung nach einem der vorhergehenden Ansprüche, **dadurch gekennzeichnet, dass** ein weiteres Flip-Flop (60) vor der Flankendifferenzierung (20) angeordnet und beschaltet ist und dazu eingerichtet ist, dass bei jeder Betätigung der Zustand des Schalters (58) wechselt, und dass der Schalter (58) ein Wechselschalter ist.

8. Schaltanordnung nach einem der vorhergehenden Ansprüche, **dadurch gekennzeichnet, dass** die autarke, lokale Stromversorgung (10) eine Batterie, insbesondere eine Knopfzelle ist.

9. Schaltanordnung nach einem der vorhergehenden Ansprüche, **dadurch gekennzeichnet, dass** der Stromverbrauch der Schaltungsanordnung bei zehn Pulsen des optischen Senders (12) pro Sekunde einen Strom von ≤ 500nA pro Stunde bei einer Spannung von 3 V beträgt.

10. Verfahren zum berührungslosen Schalten wenigstens eines elektrischen Verbrauchers (V) mit den Schritten
- Bereitstellen einer autarken, lokalen Stromversorgung (10),
- Ansteuern wenigstens eines optischen Senders (12) einer Steuereinrichtung (S) zur Erzeugung eines Lichtsignals zum Aussenden in einen Detektionsraum zur Detektion von Schaltbetätigungen eines Benutzers (B), welcher Detektionsraum zwischen dem wenigstens einen optischen Sender (12) und wenigstens einem optischen Empfänger (14) einer Empfangseinrichtung (E) aufgespannt ist,
- Empfangen eines Empfangssignals aus dem Detektionsraum infolge einer Schaltbetätigung mittels des wenigstens einen optischen Empfängers (14),
- kontinuierliches zeitabschnittsweises Versorgen der Steuereinrichtung (S) und/oder der Empfangseinrichtung (E) mittels der lokalen Stromversorgung (10) mit Strom,
- Auswerten des Empfangssignals zur Erzeugung eines Schaltsignals unter Ansteuern wenigstens eines bistabilen Relais (26) in Abhängigkeit vorgebbarer oder vorgegebener Randbedingungen,
**dadurch gekennzeichnet, dass** ein auf einer Ausgangsleitung (22) der Auswerteeinheit (A) vorhandener Signalausgang zur Erkennung von in Abhängigkeit der Randbedingungen vorhandener Flanken im Signalausgang differenziert wird und dass das wenigstens eine bistabile Relais (26) bei Vorhandensein von Flanken im Signalausgang angesteuert wird, um den Zustand des bistabilen Relais (26) für den Schaltvorgang zu wechseln.

11. Verfahren nach Anspruch 10, **dadurch gekennzeichnet, dass** wenigstens ein Flip-Flop (28) der Auswerteeinheit (A) bei Überschreiten eines Schwellwerts im Signalausgang über eine Signalausgabe (32) ein flankenbehaftete Signal auf der Ausgangsleitung (22) an das potentialfreie, bistabile Relais (26) ausgibt.

12. Verfahren nach Anspruch 10 oder 11, **dadurch gekennzeichnet, dass** die Flanken im flankenbehafteten Signal im Signalausgang auf der Ausgangsleitung (22) infolge einer Zustandsänderung im Detektionsraum differenzierbar werden, insbesondere infolge einer Annäherung und/oder Entfernung eines Objekts oder Benutzers (B).

13. Verfahren nach einem der Ansprüche 10 bis 12, **dadurch gekennzeichnet, dass** ein Clock-Generator (34) das Flip-Flop (28) über ein Timing-Element (36) zu Beginn eines Messzyklus zurücksetzt und/oder den wenigstens einen optischen Sender (12) und/oder den wenigstens einen optischen Empfänger (14) über ein Timing-Element (36) zeitweise ansteuert.

14. Verfahren nach einem der Ansprüche 10 bis 13, **dadurch gekennzeichnet, dass** ein Timing-Element (36) den optischen Sender (12) mit einer Betriebsdauer von ≤ 100 ns bei einer Pausenlänge von mehr als 80 ms betreibt.

15. Verfahren nach einem der Ansprüche 10 bis 14, **dadurch gekennzeichnet, dass** ein weiteres Flip-Flop (60) vor der Flankendifferenzierung (20) zwischengeschaltet wird, so dass bei jeder Betätigung der Zustand des Schalters (58) wechselt, und dass die Schaltung als Wechselschaltung betrieben wird.
